# EUROPEAN PATENT APPLICATION

(11) **EP 4 317 925 A1**
(43) Date of publication of application: **07.02.2024**
(21) Application number: 22779661.2
(22) Date of filing: 22.02.2022
(51) Int. Cl.: G01K 7/00, H01L 21/822, H01L 25/00, H01L 27/04

(54) **ELECTRONIC CIRCUIT DEVICE, AND TEMPERATURE MEASUREMENT METHOD OF ELECTRONIC CIRCUIT DEVICE**

(30) Priority: 31.03.2021 JP 2021058988
(71) Applicant: Furuno Electric Co., Ltd., Nishinomiya-City, Hyogo 662-8580 (JP)
(72) Inventor: YASUMOTO, Takuji, Nishinomiya-City, Hyogo 6628580 (JP)
(74) Representative: CSY London
(86) International application number: PCT/JP2022/007300
(87) International publication number: WO 2022/209436

(57) **Abstract**

A temperature of an electronic circuit device such as an integrated circuit is measured with high accuracy. The electronic circuit device (10) includes a main processor (20) and a temperature measurement module (30). The main processor (20) can execute predetermined signal processing. The temperature measurement module (30) generates a signal having a correspondence relationship with the temperature of the main processor (20) under a mode in which the temperature measurement module is driven at a predetermined low power consumption or less and the thermal resistance between the temperature measurement module and the main processor (20) is a predetermined thermal resistance value or less.

## Description

### TECHNICAL FIELD

Embodiments of the present disclosure relate to a technique for measuring a temperature of an electronic circuit device such as an IC.

### BACKGROUND

Patent Literature 1 describes a method for measuring a temperature of an integrated circuit.

Patent Literature 1: Japanese Patent Application Publication No. 2014 -510268.

However, in the above document, the temperature of the integrated circuit cannot be accurately measured.

### SUMMARY

Accordingly, an object of the present disclosure is to accurately measure the temperature of an electronic circuit device such as an integrated circuit.

### BRIEF DESCRIPTION

In accordance with an embodiment of the present disclosure,an electronic circuit device is provided. The electronic circuit device includes a main processor module configured to execute predetermined signal processing. Further, the electronic circuit device includes a temperature measurement module configured to generate an signal in correspondence with a temperature of the main processor module under a mode. The temperature measurement module is driven at a predetermined low power consumption value or less. Further, a thermal resistance between the temperature measurement module and the main processor module is a predetermined thermal resistance value or less.

In this configuration, the temperature of the main processor is observed by measuring the signal generated by the temperature measurement module.

According to the present disclosure, it is possible to accurately measure the temperature of the electronic circuit device.

### BRIEF DESCRIPTION OF THE DRAWINGS

FIG. 1 is a functional block diagram of an electronic circuit device in accordance with an embodiment of the present disclosure;
FIG. 2 is a graph showing an example of a temperature frequency characteristic of an RC oscillator in accordance with an embodiment of the present disclosure;
FIG. 3 is a flowchart illustrating an example of advance preparation of the temperature measurement method of FIG. 1 in accordance with an embodiment of the present disclosure;
FIG. 4 is a flowchart illustrating an example of a temperature measurement method in accordance with an embodiment of the present disclosure;
FIG. 5 is a functional block diagram of an electronic circuit device in accordance with another embodiment of the present disclosure; and
FIG. 6 is a functional block diagram of an electronic circuit device in accordance with yet another embodiment of the present disclosure.

### DETAILED DESCRIPTION

### [First Embodiment]

A temperature measurement technique of the electronic circuit device according to the first embodiment of the present disclosure will be described with reference to the drawings.

### [Configuration of Electronic Circuit Device (10)]

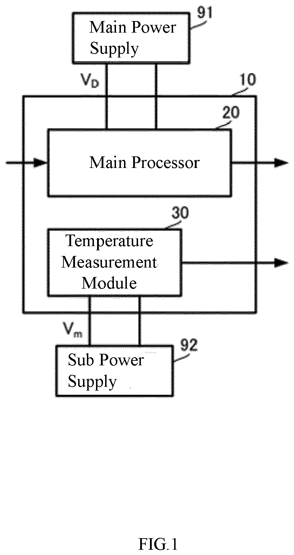

FIG. 1 is a functional block diagram of an electronic circuit device according to a first embodiment. As illustrated in FIG. 1, the electronic circuit device (10) may include a main processor (20) and a temperature measurement module (30).

Being not illustrated, the electronic circuit device (10) may be formed of a semiconductor IC. More specifically, the electronic circuit device (10) may include a substrate, a plurality of electronic circuit elements, a resin mold, and an external connection terminal. The substrate may be formed of, for example, a semiconductor (wafer). The substrate may be a substrate (circuit board) instead of a wafer. The plurality of electronic circuit elements may be formed or mounted on the substrate. The resin mold may cover the substrate and the plurality of electronic circuit elements.

The external connection terminal may be a terminal that conducts the external connection electrode of the substrate to the outside, and may be formed by a pin, a solder bump, or the like. The external connection terminal may be used for input and output of various signals, application of the drive voltage VD and the measurement voltage Vm, and the like, described later.

The main processor (20) and the temperature measurement module (30) may be realized by a plurality of electronic circuit elements, more precisely, implemented by processing circuitry (20). The main processor (20) and the temperature measurement module (30) may be filled in a resin mold.

The main processor (20) and the temperature measurement module (30) may be disposed adjacent to each other. More specifically, the temperature measurement module (30) may be disposed at a position affected by the temperature of the main processor (20). That is, the thermal resistance between the main processor (20) and the temperature measurement module (30) may be equal to or less than a predetermined thermal resistance value, and the temperature measurement module (30) may have substantially the same temperature as the main processor (20). The main processor (20) and the temperature measurement module (30) may be formed on the same substrate.

The main processor (20) may be supplied with the drive voltage VD from the main power supply (91). The main processor (20) may be driven by the drive voltage VD, perform predetermined signal processing on an input signal, for example, and output the processed signal. The main processor (20) may be driven with low power consumption (may be in a low power consumption driving state), in addition to the mode of driving with rated power consumption (power dissipation).

The temperature measurement module (30) may be supplied with the measurement voltage Vm from the temperature measurement power supply (92). The measurement voltage Vm may be lower than the drive voltage VD. More specifically, the measurement voltage Vm may be equal to or lower than the drive voltage VD when the main processor (20) is driven with low power consumption. Furthermore, the measurement voltage Vm may be set so that the temperature rise of the temperature measurement module (30) due to the measurement voltage Vm does not affect the temperature measurement of the main processor (20). For example, the measurement voltage Vm may be set such that the temperature rise during temperature measurement is less than 0.1 〈C [degree Celsius]. The specific threshold value of the temperature rise may be an example, and may be appropriately set so as to ensure the accuracy of the temperature measurement.

The temperature measurement module (30) may include an oscillator. The temperature measurement module (30) may include, for example, an RC oscillator. The temperature measurement module (30) may oscillate at an oscillation frequency in correspondence with an ambient temperature and output an oscillation signal.

In this configuration, the heat source that affects the temperature measurement module (30) by increasing the thermal resistance of the substrate and the resin mold may be substantially the main processor (20). Therefore, the temperature measurement module (30) may generate and output an oscillation signal having an oscillation frequency in correspondence with a temperature of the main processor (20).

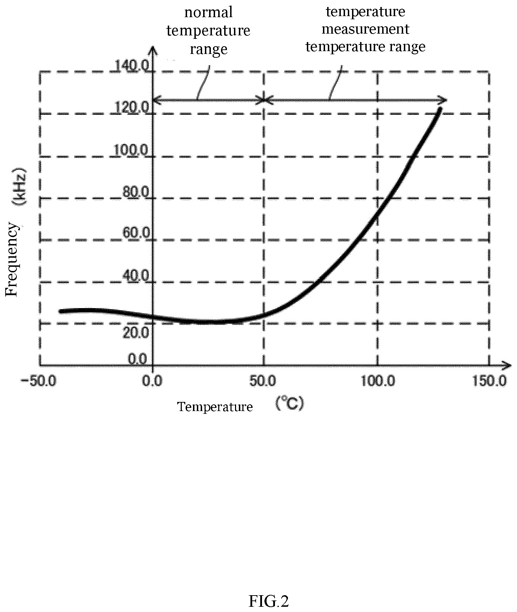

FIG. 2 is a graph illustrating an example of a temperature frequency characteristic of the RC oscillator. In the example illustrated in FIG. 2, the temperature frequency characteristic of the RC oscillator may have a normal temperature range of about 50 °C [degree Celsius] or less and a temperature measurement temperature range higher than about 50 °C [degree Celsius]. In the normal temperature range, the frequency hardly changes even when the temperature changes. In the temperature measurement temperature range, the frequency may increase as the temperature increases. The change amount of the frequency due to the temperature change in the temperature measurement temperature range may be larger than the change amount of the frequency due to the temperature change in the normal temperature range. Further, in the temperature measurement temperature range, the frequency and the temperature may have a one-to-one relationship.

Therefore, by detecting the oscillation frequency of the oscillation signal in the temperature measurement temperature range, the temperature of the main processor (20) may be measured with a predetermined accuracy.

That is, even in the main processor (20) covered with the resin mold, the temperature of the main processor (20) may be measured almost directly without estimating and measuring the temperature from the temperature outside the electronic circuit device (10). Accordingly, the temperature of the main processor (20) may be measured with higher accuracy.

Accordingly, for example, a temperature margin at the time of designing the electronic circuit device (10) may be reduced. Therefore, the entire apparatus including the electronic circuit device (10) may be designed with more appropriate specifications according to the use environment and specifications.

In the above-described embodiment, an aspect in which the temperature measurement module (30) is realized by the RC oscillator has been described. However, the temperature measurement module (30) may be adopted as long as it has a temperature range in which the oscillation frequency changes depending on the temperature and the temperature and the oscillation frequency have a one-to-one relationship.

Further, the temperature measurement module (30) may not have a linear relationship between the temperature and the frequency as long as the relationship between the temperature and the frequency is known as illustrated in FIG. 2. Accordingly, the temperature measurement module (30) may not adjust the temperature and the frequency to have a linear relationship. The temperature measurement module (30) may not be limited to the RC oscillator and may include an LC oscillator.

### [Method of Measuring Temperature of Electronic Circuit Device (10)]

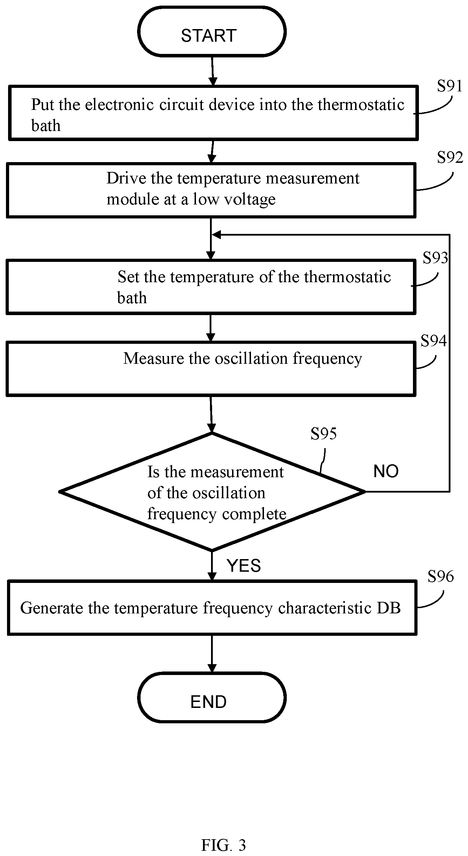

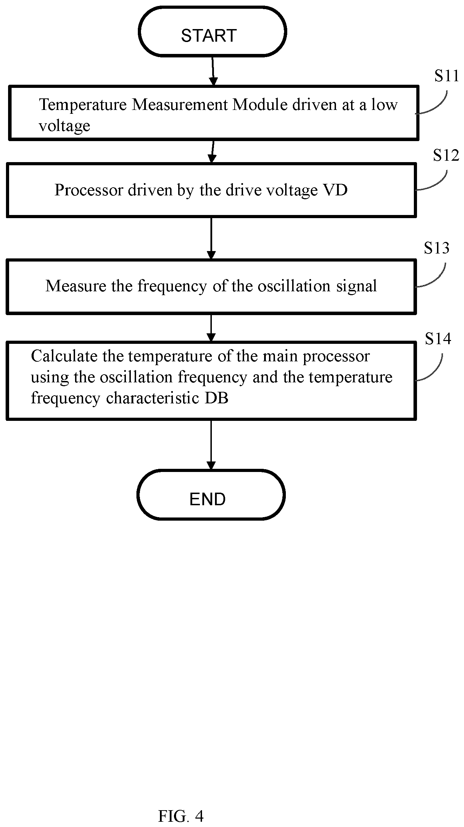

In the above-described configuration, when the temperature of the main processor (20) is measured, a method illustrated in FIGs. 3 and 4 below may be used as an example. FIG. 3 is a flowchart illustrating an example of advance preparation of the temperature measurement method according to the first embodiment. FIG. 4 is a flowchart illustrating an example of a temperature measurement method according to the first embodiment.

### [Preparation]

As shown in FIG. 3, the electronic circuit device (10) may be put into the thermostatic bath (S91). The temperature measurement module (30) of the electronic circuit device (10) may be driven at a low voltage (measurement voltage Vm) (S92).

Next, the temperature of the thermostatic bath may be set to stabilize the temperature of the thermostatic bath and the temperature of the electronic circuit device (10) (S93). After the temperature of the thermostatic bath may be stabilized, the oscillation frequency of the oscillation signal output from the temperature measurement module (30) is measured (S94). Then, the temperature of the thermostatic bath and the oscillation frequency may be recorded.

The temperature of the thermostatic bath and the electronic circuit device (10) may be changed until the measurement of the oscillation frequency with respect to the temperature is completed in the entire temperature measurement temperature range (S95: YES), and the oscillation frequency may be measured for each changed temperature.

When the measurement of the oscillation frequency with respect to the temperature may be completed over the entire temperature measurement temperature range (S95: NO), a temperature frequency characteristic DB (database) having a relationship between the measured oscillation frequency and the temperature may be generated (S96). Then, the calibration of the oscillation frequency and the temperature may be completed. The thermal resistance between the main processor (20) and the temperature measurement module (30) may not affect the temperature calibration.

### [Temperature Measurement of Electronic Circuit Device (10)]

As shown in FIG. 4, the temperature measurement module (30) may be driven at a low voltage (measurement voltage Vm) (S11). The main processor (20) may be driven by the drive voltage VD (S12).

The frequency (oscillation frequency) of the oscillation signal may be measured (S13). The temperature of the main processor (20) may be calculated using the oscillation frequency and the temperature frequency characteristic DB (S14).

Accordingly, the temperature of the main processor (20) formed inside the semiconductor IC subjected to resin molding or the like may be measured with high accuracy.

### [Second Embodiment]

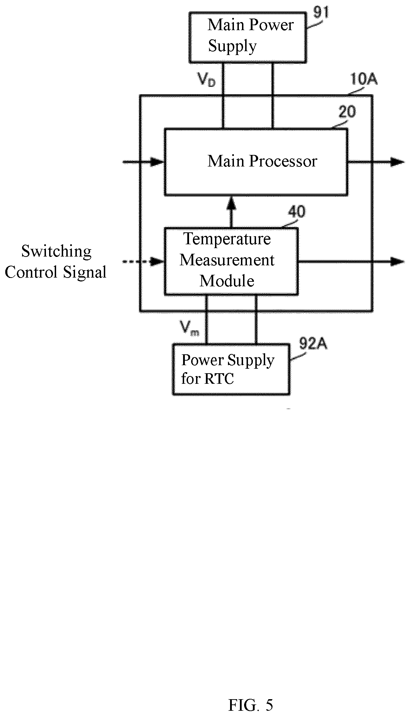

A temperature measurement technique of an electronic circuit device according to a second embodiment of the present disclosure may be described with reference to the drawings. FIG. 5 is a functional block diagram of the electronic circuit device according to the second embodiment.

As illustrated in FIG. 5, the electronic circuit device (10) according to the second embodiment may be different from the electronic circuit device (10) according to the first embodiment where the temperature measurement module (30) may be replaced with the RTC signal generator (40). Other configurations of the electronic circuit device (10) may be the same as those of the electronic circuit device (10), and the description of the same portions has been omitted.

The electronic circuit device (10) includes an RTC signal generator (40). The RTC is a real-time clock. The RTC signal generator (40) includes an RC oscillator.

The RTC signal generator (40) may generate an RTC signal based on the oscillation signal output from the RC oscillator. The RTC signal generator (40) may output the RTC signal to the main processor (20). At this time, the main processor (20) may be in a state where the power supply is cut off or where an input clock is stopped, for example.

The RTC signal generator (40) may output the oscillation signal as a temperature measurement signal.

More specifically, for example, a switching control signal may be input to the RTC signal generator (40). The switching control signal may be a control signal for switching whether the RTC mode is the temperature measurement mode.

When the RTC mode may be set by the switching control signal, the RTC signal generator (40) may output the RTC signal based on the oscillation signal to the main processor (20). At this time, the electronic circuit device (10) may be operating in the normal temperature range. Therefore, as shown in FIG. 2, the difference in the oscillation frequency depending on the temperature may be small. Accordingly, the RTC signal having a stable desired accuracy may be input to the main processor (20).

On the other hand, at the time of temperature measurement, the RTC signal generator (40) may set the temperature measurement mode by the switching control signal and output the oscillation signal. At this time, the electronic circuit device (10) may be set in the temperature measurement temperature range. Therefore, as shown in FIG. 2, the oscillation frequency may change in accordance with the temperature, and the oscillation frequency and the temperature have a one-to-one relationship. Accordingly, the temperature of the main processor (20) may be measured with high accuracy at the time of temperature measurement.

### [Third Embodiment]

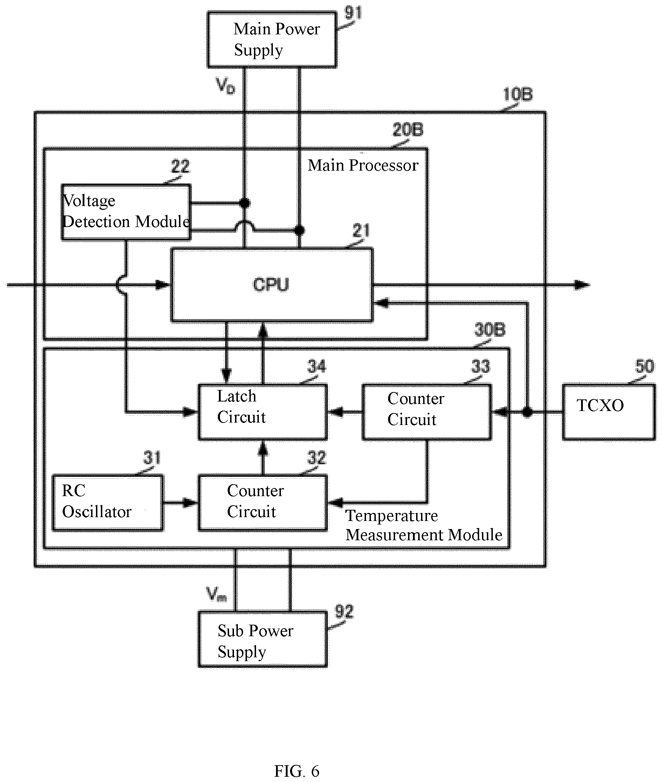

A temperature measurement technique of an electronic circuit device according to a third embodiment of the present disclosure will be described with reference to the drawings. FIG. 6 is a functional block diagram of the electronic circuit device according to the third embodiment.

As illustrated in FIG. 6, the electronic circuit device (10B) according to the third embodiment may be different from the electronic circuit device (10) according to the first embodiment in the specific configurations of the main processor (20B) and the temperature measurement module (30B). Other configurations of the electronic circuit device (10B) may be the same as those of the electronic circuit device (10), and the description of the same portions has been omitted.

The electronic circuit device (10B) may include a main processor (20B) and a temperature measurement module (30).

The main processor (20B) may include a CPU (21) and a voltage detection module (22). The CPU (21) may execute various types of signal processing executed by the main processor (20B). Further, the CPU (21) may output the output data of the latch circuit (34) of the temperature measurement module (30B) to the outside.

The temperature measurement module (30B) may include an RC oscillator (31), a counter circuit (32), a counter circuit (33), and a latch circuit (34).

The RC oscillator (31) may generate an oscillation signal having an oscillation frequency in correspondence with an ambient temperature (mainly the temperature of the main processor (20B)) and output the oscillation signal to the counter circuit (32).

The counter circuit (32) may count based on the oscillation signal and output a count value to the latch circuit (34).

The counter circuit (33) may frequency-divide a high-precision frequency signal from the external TCXO (50) to generate a latch signal and a reset signal. The counter circuit (33) may output a reset signal to the counter circuit (32) at a reset timing of measurement. The counter circuit (33) may output a latch signal to the latch circuit (34) at a predetermined cycle during measurement.

The latch circuit (34) may latch the count value of the counter circuit based on the input timing of the latch signal from the counter circuit (33). The latch circuit (34) may output the latched count value to the CPU (21). Upon receiving a voltage detection signal from the voltage detection unit of the main processor (20), the latch circuit (34) may stop the latch operation. The latch circuit (34) may execute the latch operation when the latch stop is released from the CPU (21).

In such a configuration, temperature measurement may be performed as follows.

### [Advance Preparation]

The electronic circuit device (10B) may be placed in a thermostatic bath. A measurement voltage Vm is supplied from the temperature measurement power supply (92) to drive the temperature measurement module (30B).

The counter circuit (32) may start counting by the clock of the RC oscillator (31).

The TCXO (50) may be activated to input a high-precision frequency signal. The counter circuit (33) may generate a reset signal and a latch signal based on the high-precision frequency signal.

The counter circuit (32) may reset the count at the input timing of the reset signal.

The latch circuit (34) may latch the count value from the counter circuit (32) at the input timing of the latch signal.

Next, the drive voltage VD may be supplied from the main power supply (91) to the main processor (20B). Upon detecting the drive voltage VD, the voltage detection module (22) may output a voltage detection signal to the latch circuit (34).

The latch circuit (34) may stop the latch operation based on the input of the voltage detection signal, and output the counter value at that time to the CPU (21).

The CPU (21) may convert the counter value into, for example, serial data and output the serial data.

By repeating this operation while changing the temperature of the thermostatic bath, the above-described temperature frequency characteristic DB may be obtained.

### [Temperature Measurement of Electronic Circuit Device (10B)]

When measuring the temperature of the electronic circuit device (10B) after completion of the above-described advance preparation, the CPU (21) may output a release signal for releasing the stop of the latch operation to the latch circuit (34). The latch circuit (34) may resume the latch operation based on the release signal.

Thereafter, the latch circuit may latch the count value output from the counter circuit (32) for each cycle determined by the reset signal and the latch signal, and output the count value to the CPU (21). The CPU (21) sequentially may convert the input count value into serial data and outputs the serial data.

This count value may depend on the current temperature of the main processor (20B). Therefore, by executing such processing, the temperature of the main processor (20B) may be measured with high accuracy.

By using this configuration, the electronic circuit device (10B) may use an external connection terminal used for normal processing as an output terminal of serial data for temperature measurement. As a result, an external connection terminal for temperature measurement may not be separately provided as the electronic circuit device (10B).

### [Application Example of Electronic Circuit Device]

The electronic circuit device having the above-described configuration may be applied to, for example, an IC for positioning. That is, the main processor may realize an RF receiving unit, a capturing and tracking unit, and a positioning calculation.

At this time, if the electronic circuit device (10A) may use the RTC signal generator (40), a general RTC signal for positioning may be used as a signal output from the RTC signal generator (40). In other words, the electronic circuit device (10A) may measure the temperature by the RTC signal used for positioning.

In the case of the electronic circuit device (10B) that receives an input from the TCXO (50), the TCXO (50) may be used for capturing and tracking a positioning signal, and the electronic circuit device (10B) may measure a temperature using an output signal of the TCXO (50) for capturing and tracking.

In each of the above-described embodiments, the main power supply (91) and the temperature measurement power supply (92) may be independent of each other. However, the main power supply (91) and the temperature measurement power supply (92) may be common, and different voltages may be supplied to the main processor and the temperature measurement module. However, since the main power supply (91) and the temperature measurement power supply (92) are independent of each other, for example, the above-described various types of power supply control may be easily performed.

In addition, the configurations and processes of the embodiments described above may be appropriately combined, and the operation and effect according to each combination may be achieved.

### List of Reference Numerals

10, 10A, 10B: Electronic Circuit Device
20, 20B: Main Processor
21: CPU
22: Voltage Detection Module
30, 30B: Temperature Measurement Module
31: RC Oscillator
32, 33: Counter Circuit
34: Latch Circuit
40: RTC Signal Generator
50: TCXO
91: Main Power Supply
92: Sub Power Supply (for Temperature Measurement)
VD: Drive Voltage
Vm: Voltage for Measurement

## Claims

1. An electronic circuit device, comprising:
a main processor module configured to execute predetermined signal processing; and
a temperature measurement moduleconfigured to generate an signal in correspondence with a temperature of the main processor module under a mode:
when the temperature measurement module is driven at a predetermined low power consumption value or less; and
when a thermal resistance between the temperature measurement module and the main processor module is a predetermined thermal resistance value or less.

2. The electronic circuit device according to claim 1, wherein the main processor module and the temperature measurement module are formed on the same substrate.

3. The electronic circuit device according to claim 1 or 2, wherein a power supply module configured to feed power to the temperature measurement module is independent of the main power supply module configured to feed power to the main processor module.

4. The electronic circuit device according to any of claims 1 to 3, wherein the temperature measurement module comprises an oscillator configured to generate the signal.

5. The electronic circuit device according to claim 4, wherein the oscillator is an RC oscillator.

6. The electronic circuit device according to any of claims 1 to 5, wherein the main processor module is further configured to be in a states where a power supply is cut off or in a states where an input clock is stopped.

7. The electronic circuit device according to any of claims 1 to 6, wherein the temperature measurement module is further configured to output a real-time clock signal to the main processor module.

8. The electronic circuit device according to claim 7, wherein the temperature measurement module is further configured:
to output the real-time clock signal corresponding to the signal in a normal temperature range; and
to output the signal in a temperature measurement temperature range higher than the normal temperature range.

9. The electronic circuit device according to any of claims 1 to 8, wherein the temperature measurement module is further configured:
to generate a temperature measurement signal corresponding to the frequency of the signal; and
wherein the main processor module is further configured:
to calculate the temperature based on the temperature measurement signal and output the temperature.

10. The electronic circuit device according to claim 9, wherein the temperature measurement module is further configured:
to input a measurement reference signal having a smaller temperature frequency dependence than the temperature measurement signal; and
to generate the temperature measurement signal from the signal using the measurement reference signal.

11. The electronic circuit device according to any of claims 1 to 10, wherein the main processor module is further configured to perform positioning calculation based on a received positioning signal.

12. A method for measuring temperature of an electronic circuit device, comprising:
executing predetermined signal processing;
generating an signal having an frequency in correspondence with a temperature of the main processor module under a mode:
when the temperature measurement module is driven at a predetermined low power consumption value or less; and
when a thermal resistance between the temperature measurement module and the main processor module is a predetermined thermal resistance value or less.

13. The method for measuring the temperature of the electronic circuit device according to claim 12, further comprising:
driving the temperature measurement module at a predetermined low power consumption value or less at a time for a calibration of temperature and frequency.
